(19) Europäisches Patentamt
European Patent Office
Office européen des brevets

(11) EP 3 057 237 B1

(12) **EUROPEAN PATENT SPECIFICATION**

(45) Date of publication and mention of the grant of the patent:
**16.05.2018 Bulletin 2018/20**

(21) Application number: **14852159.4**

(22) Date of filing: **06.10.2014**

(51) Int Cl.:
***G01R 31/00*** *(2006.01)*

(86) International application number:
**PCT/JP2014/076649**

(87) International publication number:
**WO 2015/053205 (16.04.2015 Gazette 2015/15)**

# (54) ELECTRONIC CONTROL DEVICE

ELEKTRONISCHE STEUERUNGSVORRICHTUNG

DISPOSITIF DE COMMANDE ÉLECTRONIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **10.10.2013 JP 2013212430**

(43) Date of publication of application:
**17.08.2016 Bulletin 2016/33**

(73) Proprietor: **Hitachi Automotive Systems, Ltd.**
**Hitachinaka-shi, Ibaraki 312-8503 (JP)**

(72) Inventors:
- **IWASAWA Hiroshi**
  **Tokyo 100-8280 (JP)**
- **HIROTSU Teppei**
  **Tokyo 100-8280 (JP)**
- **SATO Chihiro**
  **Hitachinaka-shi**
  **Ibaraki 312-8503 (JP)**

(74) Representative: **Addiss, John William et al**
**Mewburn Ellis LLP**
**City Tower**
**40 Basinghall Street**
**London EC2V 5DE (GB)**

(56) References cited:
**JP-A- H03 210 047**
**JP-A- H03 210 047**
**JP-A- 2001 244 813**
**JP-A- 2001 244 813**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 057 237 B1

Printed by Jouve, 75001 PARIS (FR)

## Description

### Technical Field

The present invention relates to an electronic control device which carries out control of an engine, etc. of an automobile and relates to a unit that carries out processing so that signals input from various sensors or switches (hereinafter, described as sensors or the like), which are attached to control targets, to the electronic control device are suitable for computing in the electronic control device.

### Background Art

Conventionally, as a unit that highly controls an engine, etc. of an automobile, there has been used an electronic control device which inputs the state of control targets from sensors or the like connected to the control targets such as the engine, etc. and drives actuators such as a fuel injector by computing results according to a computing unit such as a microcontroller. This electronic control device uses an input processing circuit which carries out processing so that various input signals from the sensors or the like are suitable to be processed in the electronic control device. Specifically, for example, when outputs of the sensors or the like or outputs of switches expressed as opening/closing of contact points, which have variable resistance values like thermistors or potentiometers, are converted to voltage signals by pull-up/pull-down resistors, A/D conversion enables the signals to be directly handled by a computing unit in the electronic control device such as a microcomputer.

The input processing circuit like this may have various forms. For example, a sensor abnormality diagnosis device according to PTL 1 discloses an example in which inputs from sensors are converted to voltage signals by pull-up/pull-down resistors, furthermore, the resistance values of the pull-up/pull-down resistors are changed, and malfunctioning of the sensors can be diagnosed by evaluating responses in this process. Another known kind of input processing circuit is disclosed in PTL 2.

### Citation List

#### Patent Literature

PTL 1: Japanese Patent Application Laid-Open No. H3-21004
PTL 2: Japanese Patent Application Laid-Open No. 2001-244813

### Summary of Invention

#### Technical Problem

Generally, high reliability and safety are required for control systems of automobiles including electronic control devices, particularly, for the control systems related to important functions such as engines . In order to realize safety from a viewpoint of function safety for which importance has been particularly increased recently, a function of diagnosing malfunctioning of the elements which constitute the control system is required. PTL 1 shows an example which enables detection of malfunctioning of the sensors, which constitute the control system, by varying the pull-up/pull-down resistance values.

On the other hand, in order to ensure reliability and safety of the control system, diagnosis of the pull-up/pull-down resistors per se is also required. This is for a reason that, if the pull-up/pull-down resistors cause malfunctioning such as disconnection, short-circuiting, and drift of the resistance values, the input signals from the sensors or the like cannot be correctly processed, and there is a risk of carrying out erroneous control.

Particularly when the pull-up/pull-down resistance values are variable, the mechanism therefor becomes complex, and a malfunctioning rate is generally increased compared with the case in which the pull-up/pull-down resistance values are not variable. Therefore, there is a problem that the necessity of diagnosis is high.

The present invention has been accomplished in view of the above described points, and it is an object to provide an electronic control device, wherein, in an input processing circuit of the electronic control device capable of varying resistance values of pull-up/pull-down resistors, whether the resistance values of the pull-up/pull-down resistors are designed values can be diagnosed.

Solution to Problem

According to a first aspect of the present invention there is provided an electronic control device as specified in claim 1.
According to a second aspect of the present invention there is provided an electronic control device as specified in claim 5.

Advantageous Effects of Invention

According to the present invention, the resistance value of the set pull-up resistor and/or pull-down resistor can be diagnosed, and malfunctioning such as disconnection, short-circuiting, and drift of the resistance value can be diagnosed by comparing that with an expected value.

Brief Description of Drawings

[Fig. 1] Fig. 1 is a functional block diagram showing a configuration of an electronic control device 1 of a first embodiment of the present invention.
[Fig. 2] Fig. 2 is a circuit diagram showing a configuration example of a comparator unit 5 of the first embodiment of the present invention.
[Fig. 3] Fig. 3 is a correspondence table of a voltage V44 and comparator output logics of the first embodiment of the present invention.
[Fig. 4] Fig. 4 is a functional block diagram showing a configuration of an electronic control device 1 of a second embodiment of the present invention.
[Fig. 5] Fig. 5 is a correspondence table of a voltage V44 and abnormality presence/absence judgement of the second embodiment of the present invention.
[Fig. 6] Fig. 6 is a flow chart of the abnormality presence/absence judgement of the second embodiment of the present invention.
[Fig. 7] Fig. 7 is a functional block diagram showing a configuration of an electronic control device 1 of a third embodiment of the present invention.

Description of Embodiments

First Embodiment

Hereinafter, an electronic control device according to a first embodiment of the present invention will be described by using drawings.

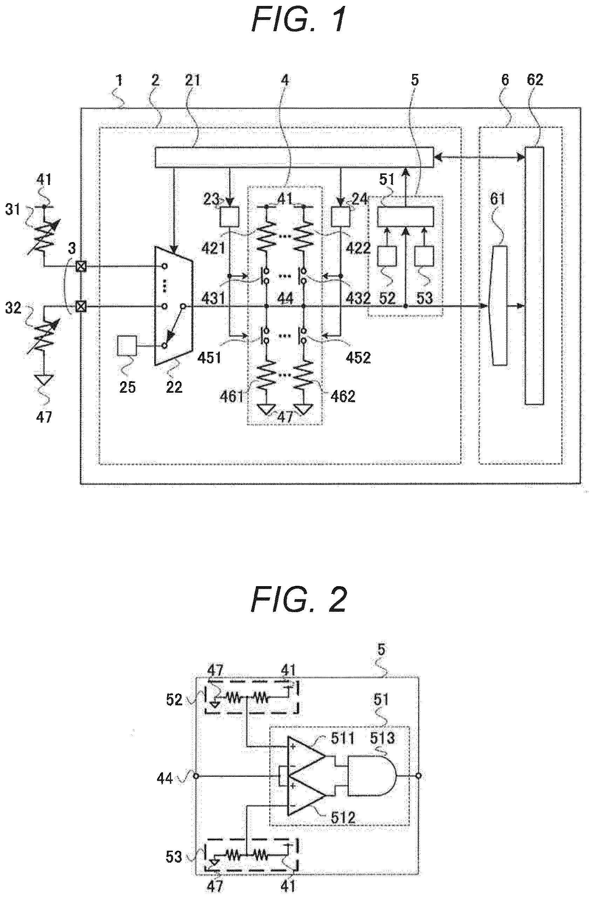

Fig. 1 is a block diagram showing a configuration of an electronic control device 1 of the present embodiment.
The electronic control device 1 is composed of an input processing circuit 2, a microcomputer 6, and an unshown output unit, and a plurality of sensors or the like 31 and 32 are connected to input terminals 3 thereof. The sensors or the like 31 and 32 are mounted on unshown control targets and have characteristics that the resistance values thereof are changed depending on the state of the control targets.
Meanwhile, one end thereof is connected to power-source wiring 41 or GND wiring 47, and the other end thereof is connected to the input processing circuit 2 via the input terminals 3.
Hereinafter, first, operations of the input processing circuit 2 in a case of normal operations will be described. A control circuit 21 is a circuit which carries out control of circuits in the input processing circuit 2 and is controlled by a computing unit 62 in the microcomputer 6. In detail, selection operations of a multiplexer 22 and setting of a pull-up/pull-down setting register 23 and the pull-up/pull-down diagnosis register 24 are carried out, and output from a window comparator 51 is transmitted to the computing unit 62.
One signal is selected by the multiplexer 22 from among the signals input to the input terminals 3, is connected to an intermediate point 44 of a pull-up/pull-down resistor group 4, and, at the same time, is input to an AD converter 61 in the microcomputer 6. Since the sensors or the like 31 and 32 are connected by time-division by using the multiplexer 22 in this manner, the circuits in the subsequent stage of the multiplexer can be shared, and the circuit size thereof can be reduced.
The AD converter 61 converts the voltage of the input signal to a digital signal and transmits that to the computing unit 62. The computing unit 62 determines the state of the control target based on the input signal, carries out control computing, gives instructions to the unshown output unit, and realizes intended control.

The pull-up/pull-down resistor group 4 is composed of common power-source wiring 41, a plurality of pull-up resistors 421 and 422, a plurality of pull-up selecting switches 431 and 432, the intermediate point 44, a plurality of pull-down selecting switches 451 and 452, a plurality of pull-down resistors 461 and 462, and common GND wiring 47. The pull-up resistors 421 and 422 have mutually different resistance values and are selectively connected to the intermediate point 44 by the pull-up selecting switches 431 and 432, thereby realizing pull-up processing with an arbitrary resistance value. Similarly, the pull-down resistors 461 and 462 have mutually different resistance values and are selectively connected to the intermediate point 44 by the pull-down selecting switches 451 and 452, thereby realizing pull-down processing with an arbitrary resistance value.

Note that the pull-up resistors 421 and 422 and the pull-down resistors 461 and 462 are configured to have approximately equal resistance values of the respective combinations thereof. For example, if the pull-up resistors 421 and 422 are composed of resistors of 1 kΩ and 10 kΩ, the pull-down resistors 461 and 462 are similarly composed of resistors of 1 kΩ and 10 kΩ. This is a configuration which is required in a later-described operation of malfunction diagnosis.

The pull-up selecting switches 431 and 432 and the pull-down selecting switches 451 and 452 are composed of analog switches, and ON/OFF thereof is controlled to be ON when one of or both of corresponding bits of the pull-up/pull-down setting register 23 and the pull-up/pull-down diagnosis register 24 is true. However, in a normal operation, the pull-up/pull-down diagnosis register 24 is not used, and only the pull-up/pull-down setting register 23 is used. The selected (turned ON) pull-up selecting switch may be only single, or a configuration which realizes more various resistance values by synthesizing resistance values by turning ON two or more switches at the same time may be employed. Meanwhile, a configuration in which an arbitrary bias voltage is applied to the sensor or the like by connecting the pull-up resistor and the pull-down resistor at the same time may be employed.

This is the operation of the input processing circuit 2 in the case of a normal operation. By switching the signals (sensors or the like), which are serving as targets, by the multiplexer 22 in accordance with needs and carrying out similar operations, input processing of carrying out pull-up processing or pull-down processing with an arbitrary resistance value with respect to the plurality of connected sensors or the like can be realized.

Next, operations of the input processing circuit 2 in a case of malfunction diagnosis will be described. Herein, the operations of a case in which the resistance value of the pull-up resistor 421 is diagnosed will be described.

First, the multiplexer 22 temporarily stops the connections to the sensors or the like 31 and 32 and connects to a diagnosis-dedicated no-connection input 25. This is for avoiding the influence of the input from the sensors or the like 31 and 32 and obtaining a stable diagnosis result. Note that the no-connection input 25 of the present embodiment may truly have no connection or may be connected to the power-source wiring 41 or the GND wiring 47 with impedance which is sufficiently higher than the resistance values of the resistors in the pull-up/pull-down resistor group 4.

Then, the pull-up/pull-down setting register 23 is set so that only the pull-up resistor 421 is connected to the intermediate point 44. Then, the pull-up/pull-down diagnosis register 24 is set so that the pull-down resistor 461, which has the same resistance value as that of the pull-up resistor 421, is connected to the intermediate point 44. Herein, the resistance value of the pull-up resistor 421 is assumed to be R421, and the resistance value of the pull-down resistor 461 is assumed to be R461; in this case, the voltage (V44) of the intermediate point 44 is subjected to voltage dividing by the voltage (V41) of the power-source wiring 41 and the voltage (0) of the GND wiring 47 and becomes the voltage represented by below Formula 1.

$$V44 = V41 \times R461/(R421 + R461) \quad \cdots \text{Formula 1}$$

Herein, if both of the pull-up resistor 421 and the pull-down resistor 461 are normal (R421 = R461), it becomes a voltage Vh which is exactly the middle as shown in below Formula 2.

$$V44 = V41/2 = Vh \quad \cdots \text{Formula 2}$$

On the other hand, if the resistance value of either one of the pull-up resistor 421 or the pull-down resistor 461 is abnormal, the voltage-dividing result is deviated from this voltage. For example, if the pull-up resistor 421 is disconnected (R421 = infinite), the voltage (0) of the GND wiring appears at the intermediate point 44. Meanwhile, if the pull-up resistor 421 is short-circuited, the voltage V41 of the power-source wiring appears at the intermediate point 44.

By utilizing this characteristic and judging whether the voltage of the intermediate point 44 is deviating from Vh, malfunctioning of the pull-up resistor 421 and the pull-down resistor 461 can be judged. This judgement is carried out by the comparator unit 5.

The comparator unit 5 is composed of the window comparator 51, an upper-limit threshold voltage source 52, and a lower-limit threshold voltage source 53. The internal configuration of the comparator unit is shown in Fig. 2.

The upper-limit threshold voltage source 52 and the lower-limit threshold voltage source 53 are composed of fixed voltage-dividing circuits and generate unique voltages (V52 and V53, respectively) between the voltage V41 of the power-source wiring 41 and the voltage (0) of the GND wiring 47. V52 and V53 are set so as to satisfy a below inequality of Formula 3. $V53 < Vh < V52$ ··· Formula 3

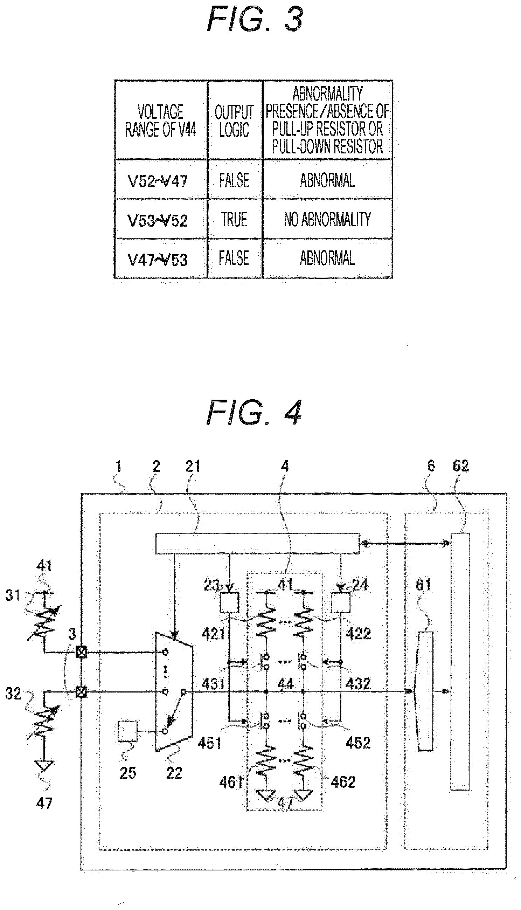

The window comparator 51 is composed of analog comparators 511 and 512 and an AND circuit 513 and outputs digital values as shown in a correspondence table shown in Fig. 3 depending on the voltage V44 of the input point. By employing this configuration, if V44 is in the vicinity of Vh, in other words, there is no abnormality in the resistance value of the pull-up resistor or the pull-down resistor, true output can be obtained; and, if V44 is deviated from the vicinity of the intermediate point, in other words, there is abnormality in the pull-up resistor or the pull-down resistor, false output can be obtained.

Note that the difference between V53 and Vh and the difference between Vh and V52 are margins for reducing erroneous reports caused by the errors which are within a normal range, and the differences are set based on the errors which are allowable with respect to the pull-up resistors and the pull-down resistors. Note that, by employing a configuration in which the margins to reduce the erroneous reports are set depending on the types, etc. of the connected sensors or the like, a configuration can be also implemented in which an effect of reducing the erroneous reports in a necessary and sufficient manner can be obtained.

The control circuit 21 transmits the output value of the comparator unit 5, which has been obtained in this manner, to the computing unit 62.

The computing unit 62 can easily carry out diagnosis of malfunctioning based on this value.

These are the operations of the input processing circuit 2 in the case of malfunctioning diagnosis in the present embodiment. According to the present embodiment, abnormality in the resistance values of the pull-up resistors and the pull-down resistors can be diagnosed. In the present embodiment, a point that diagnosis of the resistance value of the pull-up/pull-down resistor can be carried out without carrying out significant addition of circuits by utilizing, also for diagnosis, the configuration used in a resistance-value variable function of the pull-up/pull-down resistor serving as an original function is a major characteristic.

Note that, in the present embodiment, the connection of the pull-down resistor 461 uses the pull-up/pull-down diagnosis register 24 instead of the pull-up/pull-down setting register 23, and, by virtue of this configuration, malfunctioning of the pull-up/pull-down setting register 23 per se can be also diagnosed. More specifically, in a case of a state that all bits of the pull-up/pull-down setting register 23 are fixed to the values representing switch OFF and are malfunctioning and that the resistors cannot be connected to the intermediate point 44 even when the register is set, if the (malfunctioning) pull-up/pull-down setting register 23 is used also in the connection of the pull-down resistor 461, both of the pull-up resistor 421 and the pull-down resistor 461 are not connected to the intermediate point 44, and the voltage V44 of the intermediate point 44 becomes indefinite. In this case, if V44 is accidentally in the vicinity of Vh, it is diagnosed to be normal regardless of the presence/absence of abnormality in the resistance value.

On the other hand, if the diagnosis-dedicated pull-up/pull-down diagnosis register 24 is used in the connection of the pull-down resistor 461 like the present embodiment, the pull-down resistor 461 is connected regardless of malfunctioning of the pull-up/pull-down setting register 23, and, therefore, the voltage of the intermediate point 44 becomes the vicinity of 0, which is an abnormal region, and can be diagnosed as malfunctioning.

By employing this configuration, malfunctioning of the pull-up/pull-down setting register 23 per se can be also diagnosed.

The above description is an example of diagnosing the pull-up resistor 421 and the pull-down resistor 461. However, by switching the pull-up resistor and pull-down resistor connected to the intermediate point 44 in accordance with needs and carrying out similar operations, diagnosis of malfunctioning can be carried out with respect to the plurality of pull-up resistors and pull-down resistors. Herein, the control circuit 21 may transmit the diagnosis result of each resistor of the diagnosis target to the computing unit 62 or, after diagnosis of all the resistors of the diagnosis targets is completed, may collectively transmit the diagnosis results thereof to the computing unit 62. Particularly in the latter case, there is an advantage that computing load in the computing unit 62 can be reduced.

Note that, as described above, since the above described diagnosis is carried out by connecting the input of the multiplexer 22 to the no-connection input 25 for diagnosis, this cannot be carried out at the same time as a normal input processing operation, but has to be exclusively carried out. In order to realize this, this can be realized by employing a method of carrying out in a time period such as that immediately after key-ON, after key-OFF, or idling-stopped period of an automobile when stopping a normal operation and dedicating to diagnosis is allowed or a method of alternately carrying out the input processing of a normal operation and the input processing of the malfunctioning diagnosis by time division.

Moreover, the electronic control device 1 of the present embodiment has a characteristic that a unique through-current flows from the power-source wiring 41 toward the GND wiring 47 since the pull-up resistor and the pull-down resistor of the diagnosis target are temporarily connected at the same time for diagnosis. More specifically, when the pull-up resistor 421 and the pull-down resistor 461 are connected to the intermediate point 44 for diagnosis, a through-current Ip expressed by below Formula 4 flows from the power-source wiring 41 toward the GND wiring 47.

$$Ip = V41/(R421 + R461) \quad \cdots \text{ Formula 4}$$

Moreover, in the present embodiment, the resistance values of the pull-up resistor and the pull-down resistor connected in the malfunctioning diagnosis are approximately equal; however, the configuration of the present invention is not limited by this. More specifically, even when the resistance values of the pull-up resistor and the pull-down resistor connected in malfunctioning diagnosis are different from each other, similar diagnosis can be carried out by setting the upper-limit threshold voltage and the lower-limit threshold voltage used in the malfunctioning determination to the values obtained by adding/subtracting margins to/from the value of V44 calculated by Formula 1. However, as shown in the present embodiment, the case in which the resistance values of the pull-up resistor and the pull-down resistor are approximately equal is preferred since the resistance values can be diagnosed under the condition that the sensitivity to V44 from the errors of the resistors is the highest.

Second Embodiment

Next, as an electronic control device according to a second embodiment, an example which realizes similar effects by a method different from the first embodiment will be described by using drawings. Fig. 4 is a block diagram showing the configuration of an electronic control device 1 of the present embodiment. A difference in a hardware configuration between the present embodiment and the above described first embodiment is a point that the comparator unit 5, which is provided in the first embodiment, is not provided. Moreover, a difference in operation between the present embodiment and the above described first embodiment is a point that the comparison between the intermediate voltage 44 and the voltage Vh, which is carried out in the comparator unit 5 in the first embodiment, is carried out in the microcomputer 6.

Hereinafter, operations of the input processing circuit 2 and the microcomputer 6 in the present embodiment will be described. First, the operations of the input processing circuit 2 and the microcomputer 6 in normal operations are the same as those of the first embodiment.

Next, the operations of the input processing circuit 2 and the microcomputer 6 in a case in which the resistance value of the pull-up resistor 421 is diagnosed in malfunctioning diagnosis will be described. Also in the malfunctioning diagnosis, the no-connection input 25 is connected to the intermediate point 44 by the multiplexer 22, then the pull-up resistor 421 and the pull-down resistor 461 having the approximately equal resistance value as the resistor is connected, and V44 becomes the voltage expressed by Formula 1; and, until this point, the operations are the same as the operations of the first embodiment. However, the operations after this are different.

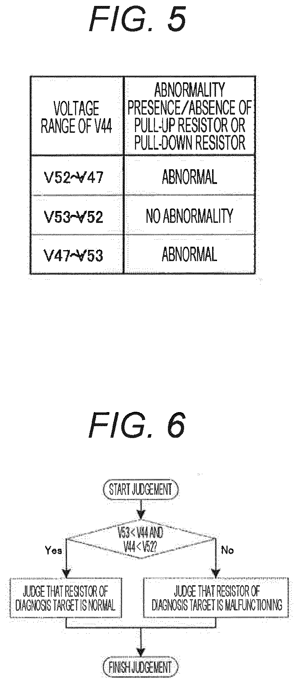

In the present embodiment, the voltage of V44 is converted to digital values by the AD converter 61 as well as a normal operation and is input to the computing unit 62. Then, in the computing unit 62, in accordance with a correspondence table shown in Fig. 5, whether the voltage of V44 shows abnormality of the pull-up resistor 421 or the pull-down resistor 461 is judged.

More specifically, as well as the first embodiment, the upper-limit threshold voltage V52 and the lower-limit threshold voltage V53 are selected so as to satisfy the inequality of Formula 3 and are stored in a memory area (not shown), which is present in the computing unit 62. Then, in the computing unit 62, in accordance with a flow chart shown in Fig. 6, malfunctioning judgement is carried out according to measurement of V44 and the magnitude relations of V44, V53, and V52. The operations herein are implementation of the function, which has been carried out by the window comparator 51 in the first embodiment, by a program in the computing unit 62.

These are the operations of the input processing circuit 2 in the malfunctioning diagnosis of the present embodiment. According to the present embodiment, as well as the first embodiment, abnormality in the resistance values of the pull-up resistor and the pull-down resistor can be diagnosed. Moreover, compared with the first embodiment, hardware required for diagnosis can be further reduced. However, on the other hand, there is a tradeoff that the processing load in the computing unit 62 is increased.

Note that the above description is an example of diagnosing the pull-up resistor 421 and the pull-down resistor 461. However, by switching the pull-up resistor and the pull-down resistor connected to the intermediate point 44 in accordance with needs and carrying out similar operations, diagnosis of malfunctioning can be carried out with respect to the plurality of pull-up resistors and pull-down resistors.

Moreover, in the present embodiment, the resistance values of the pull-up resistor and the pull-down resistor connected in the malfunctioning diagnosis are approximately equal; however, the configuration of the present invention is not limited by this. More specifically, even when the resistance values of the pull-up resistor and the pull-down resistor connected in malfunctioning diagnosis are different from each other, similar diagnosis can be carried out by setting the upper-limit threshold voltage V52 and the lower-limit threshold voltage V53 used in the malfunctioning determination to the values obtained by adding/subtracting margins to/from the value of V44, which is calculated by Formula 1 when the resistance values are normal. However, the case in which the resistance values of the pull-up resistor and the pull-down resistor are approximately equal is preferred since the resistance values can be diagnosed under the condition that the sensitivity to V44 from the errors of the resistors is the highest.

Third Embodiment

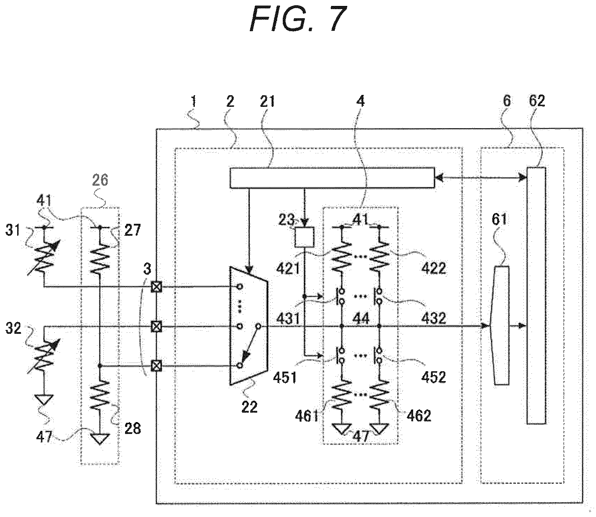

Next, as an electronic control device according to a third embodiment of the present invention, an example in which similar effects are realized by a further different method will be described by using drawings. Fig. 7 is a block diagram showing the configuration of an electronic control device 1 of the present embodiment. Differences in a hardware configuration between the present embodiment and the above described second embodiment is a point that the options of the multiplexer 22 in malfunctioning diagnosis is an external reference resistor group 26, which is composed of external resistors 27 and 28, and a point that the pull-up/pull-down diagnosis register 24 is removed.

Moreover, as a difference in operations between the present embodiment and the above described second embodiment, while both of the pull-up resistor 421 and the pull-down resistor 461 are connected to the intermediate point 44 in the malfunctioning diagnosis in the second embodiment, the present embodiment is different in a point that only one resistor (pull-up resistor or pull-down resistor) of a diagnosis target is connected.

Hereinafter, operations of the input processing circuit 2 and the microcomputer 6 in the present embodiment will be described. First, the operations of the input processing circuit 2 and the microcomputer 6 in normal operations are the same as those of the first and second embodiments.

Next, operations of the input processing circuit 2 and the microcomputer 6 in a case in which the resistance value of the pull-up resistor 421 is diagnosed in malfunctioning diagnosis will be described.

First, the multiplexer 22 temporarily stops connection to the sensors or the like 31 and 32 and, instead, connects to the reference resistor group 26. The reference resistor group 26 is composed of the reference resistors 27 and 28, which are connected in series and have known resistance values, the reference resistors 27 and 28 are connected in series, a connection point thereof is connected to the input terminal 3, the other end of the reference resistor 27 is connected to the power-source wiring 41, and the other end of the reference resistor 28 is connected to the GND wiring 47.

Then, the pull-up/pull-down setting register 23 is set so that only the pull-up resistor 421, which is a diagnosis target, is connected to the intermediate point 44. Herein, the resistance value of the pull-up resistor 421 of the diagnosis target is assumed to be R421, the resistance value of the reference resistor 27 is assumed to be R27, and the resistance value of the reference resistor 28 is assumed to be R28; in this case, the voltage (V44) of the intermediate point 44 is subjected to voltage-dividing by the voltage (V41) of the power-source wiring 41 and the voltage (0) of the GND wiring 47 and becomes the voltage expressed by below Formula 6.

$$V44 = V41 \times R28 \times (R27 + R421)/(R27 \times R28 + R27 \times R421 + R28 \times R421) \quad \cdots \text{Formula 6}$$

The voltage of V44 obtained in this manner is converted to digital values by the AD converter 61 as well as normal operations and is input to the computing unit 62. Then, in the computing unit 62, in accordance with the correspondence table shown in Fig. 5, whether the voltage of V44 is showing abnormality of the pull-up resistor 421 or the pull-down resistor 461 is judged.

More specifically, a voltage Vn44 of V44 of a normal case is calculated by using Formula 6 from the resistance value of the pull-up resistor 421 of a normal case, and the upper-limit threshold voltage V52 and the lower-limit threshold voltage V53 are selected so as to satisfy the inequality of Formula 6 and are stored in the memory area (not shown), which is present in the computing unit 62. Then, the computing unit 62 carries out malfunctioning judgement according to measurement of V44 and the magnitude relations of V44, V53, and V52 in accordance with the flow chart shown in Fig. 6. Herein, in the present embodiment, different from the second embodiment, the voltage Vn44 of V44 of a normal case is different every time depending on the resistance value of the resistor of the diagnosis target, and, therefore, attention is required for the point that the calculations have to be carried out every time.

These are the operations of the input processing circuit 2 in the malfunctioning diagnosis of the present embodiment. According to the present embodiment, as well as the first and second embodiments, abnormality in the resistance values of the pull-up resistors and the pull-down resistors can be diagnosed.

The above description is about the case in which the resistance value of the pull-up resistor 421 is diagnosed. However, if the pull-down resistor 461 is a diagnosis target, similar diagnosis operations can be carried out by setting the pull-up/pull-down setting register 23 so that only the pull-up resistor 461 is connected to the intermediate point 44.

However, there is a different point that the voltage (V44) of the intermediate point 44 of this case becomes the voltage expressed by below Formula 7, wherein the resistance value of the pull-down resistor 461 is R461.

$$V44 = V41 \times R28 \times R461/(R27 \times R28 + R27 \times R461 + R28 \times R461) \quad \cdots \text{ Formula 7}$$

Note that, regarding the counterpart of voltage-dividing in diagnosis of the resistance value, compared with the first and second embodiments in which the resistor in the pull-up/pull-down resistor group 4 is used as the resistor, the reference resistors 27 and 28, which are externally connected, are commonly used in the present embodiment, and there is an advantage that it is easy to ensure absolute precision. More specifically, in the first and second embodiments, the diagnosis precision of the resistance value depends on the resistance precision of the resistors in the pull-up/pull-down resistor group 4, and all of the resistors in the pull-up/pull-down resistor group 4 have to have high precision to carry out high-precision diagnosis.

On the other hand, in the present embodiment, the diagnosis precision of the resistance value depends only on the precision of the reference resistors 27 and 28, and high-precision diagnosis can be realized when these two resistors have high precision. This advantage becomes notable particularly when the input processing circuit 2 including the pull-up/pull-down resistor group 4 is formed into an integrated circuit (IC). This is for a reason that, generally in an integrated circuit, it is comparatively easy to relatively equalize the resistance values among resistors, but it is difficult to carry out manufacturing with highly-precise absolute resistance values.

Reference Signs List

1: electronic control device, 2: input processing circuit, 21: control circuit, 22: multiplexer, 23: pull-up/pull-down setting register, 24: pull-up/pull-down diagnosis register, 26: reference resistor group, 3: input terminal, 31, 32: sensors or the like, 4: pull-up/pull-down resistor group, 41: power-source wiring, 421, 422: pull-up resistors, 431, 432: pull-up selecting switches, 451, 452: pull-down selecting switches, 461, 462: pull-down resistors, 47: GND wiring, 5: comparator unit, 51: window comparator, 6: microcomputer, 61: AD converter, 62: computing unit

## Claims

1. An electronic control device (1) having an input processing circuit (2) comprising selecting switches (431, 432, 451, 452) adapted to connect at least one of a plurality of pull-up resistors (421, 422) and/or at least one of a plurality of pull-down resistors (461, 462) to an input signal from outside, the input processing circuit (2) having a unit adapted to diagnose whether the resistance value of the at least one pull-up resistor (421, 422) and/or the at least one pull-down resistor (461, 462) is within an expected range,
   wherein the input processing circuit (2) is adapted to connect one of the plurality of pull-down resistors (461, 462) to the at least one pull-up resistor (421, 422) when the resistance value of the at least one pull-up resistor (421, 422) is to be diagnosed, to connect one of the plurality of the pull-up resistors (421, 422) to the at least one pull-down resistor (461, 462) when the resistance value of the at least one pull-down resistor (461, 462) is to be diagnosed, and the unit adapted to diagnose whether the resistance value of the at least one pull-up resistor (421, 422) and/or the at least one pull-down resistor (461, 462) is within the expected range is adapted to carry out the diagnosis by checking whether the voltage of an intermediate point (44) between the plurality of pull-up resistors (421, 422) and the plurality of pull-down resistors (461, 462) is within an expected range.

2. The electronic control device (1) according to claim 1, wherein
   a ratio of the resistance values of the pull-up resistor (421, 422) and the at least one pull-down resistor (461, 462) mutually connected in the diagnosis of the resistance value, or the ratio of the resistance values of the pull-down resistor (461, 462) and the at least one pull-up resistor (421, 422) mutually connected in the diagnosis of the resistance value, is approximately 1:1.

3. The electronic control device (1) according to claim 1, wherein
   the unit adapted to diagnose whether the resistance value of the at least one pull-up resistor (421, 422) and/or the at least one pull-down resistor (461, 462) is within the expected range is adapted to perform the checking whether the voltage of the intermediate point (44) between the plurality of pull-up resistors (421, 422) and the plurality of pull-down resistors (461, 462) is within the expected range by using a window comparator (51).

**4.** The electronic control device (1) according to claim 1, comprising a setting memory area (23) that is independent from other memory areas, and wherein the input processing circuit (2) is configured to set the setting memory area (23) in order to select the pull-up resistor (421, 422) or the pull-down resistor (461, 462) to be connected for the diagnosis.

**5.** An electronic control device (1) having an input processing circuit (2) comprising selecting switches (431, 432, 451, 452) adapted to connect at least one of a plurality of pull-up resistors (421, 422) and/or at least one of a plurality of pull-down resistors (461, 462) to an input signal from outside, the input processing circuit (2) having a unit adapted to diagnose whether the resistance value of the at least one pull-up resistor (421, 422) and/or the at least one pull-down resistor (461, 462) is within an expected range,
wherein the input processing circuit (2) is adapted to connect the at least one pull-up resistor (421, 422) or the at least one pull-down resistor (461, 462) to an externally-connected reference resistor group (27, 28) having a known resistance value, wherein the externally-connected reference resistor group (27, 28) has other ends connected to power-source wiring (41) and GND wiring (47), and the unit adapted to diagnose whether the resistance value of the at least one pull-up resistor (421, 422) and/or the at least one pull-down resistor (461, 462) is within an expected range is adapted to carry out the diagnosis by checking whether the voltage of an intermediate point (44) between the externally-connected reference resistor group (27, 28), the plurality of pull-up resistors (421, 422) and the plurality of pull-down resistors (461, 462) is within an expected range.

**Patentansprüche**

**1.** Elektronische Steuervorrichtung (1) mit einer Eingangsverarbeitungsschaltung (2), die Wählschalter (431, 431, 451, 452) umfasst, die geeignet sind, um zumindest einen aus einer Vielzahl von Pull-up-Widerständen (421, 422) und/oder zumindest einen aus einer Vielzahl von Pull-down-Widerständen (461, 462) mit einem Eingangssignal von außen zu verbinden, wobei die Eingangsverarbeitungsschaltung (2) eine Einheit aufweist, die geeignet ist, um zu diagnostizieren, ob der Widerstandswert des zumindest einen Pull-up-Widerstands (421, 422) und/oder des zumindest einen Pull-down-Widerstands (461, 462) innerhalb eines erwarteten Bereichs liegt,
wobei die Eingangsverarbeitungsschaltung (2) geeignet ist, um einen aus der Vielzahl von Pull-down-Widerständen (461, 462) mit dem zumindest einen Pull-up-Widerstand (421, 422) zu verbinden, wenn der Widerstandswert des zumindest einen Pull-up-Widerstands (421, 422) diagnostiziert werden soll, einen aus der Vielzahl von Pull-up-Widerständen (421, 422) mit dem zumindest einen Pull-down-Widerstand (461, 462) zu verbinden, wenn der Widerstandswert des zumindest einen Pull-down-Widerstands (461, 462) diagnostiziert werden soll, und die Einheit, die geeignet ist, um zu diagnostizieren, ob der Widerstandswert des zumindest einen Pull-up-Widerstands (421, 422) und/oder des zumindest einen Pull-down-Widerstands (461, 462) in dem erwarteten Bereich liegt, geeignet ist, um die Diagnose durch Überprüfen, ob die Spannung an einem Punkt (44) zwischen der Vielzahl von Pull-up-Widerständen (421, 422) und der Vielzahl von Pull-down-Widerständen (461, 462) in einem erwarteten Bereich liegt, durchzuführen.

**2.** Elektronische Steuervorrichtung (1) nach Anspruch 1, wobei
ein Verhältnis des Widerstandswerts des Pull-up-Widerstands (421, 422) und des zumindest einen Pull-down-Widerstands (461, 462), die zur Diagnose des Widerstandswerts miteinander verbunden sind, oder das Verhältnis des Pull-down-Widerstands (461, 462) und des zumindest einen Pull-up-Widerstands (421, 422), die zur Diagnose des Widerstandswerts miteinander verbunden sind, etwa 1:1 beträgt.

**3.** Elektronische Steuervorrichtung (1) nach Anspruch 1, wobei
die Einheit, die geeignet ist, zu diagnostizieren, ob der Widerstandswert des zumindest einen Pull-up-Widerstands (421, 422) und/oder des zumindest einen Pull-down-Widerstands (461, 462) im erwarteten Bereich liegt, geeignet ist, um die Überprüfung durchzuführen, ob die Spannung an dem Punkt (44) zwischen der Vielzahl von Pull-up-Widerständen (421, 422) und der Vielzahl von Pull-down-Widerständen (461, 462) im erwarteten Bereich liegt, indem ein Fensterkomparator (51) verwendet wird.

**4.** Elektronische Steuervorrichtung (1) nach Anspruch 1, die einen Einstellspeicherbereich (23) umfasst, der von anderen Speicherbereichen unabhängig ist, und wobei die Eingangsverarbeitungsschaltung (2) ausgebildet ist, um den Einstellspeicherbereich (23) einzustellen, damit der Pull-up-Widerstand (421, 422) oder Pull-down-Widerstand (461, 462) ausgewählt wird, der für die Diagnose anzuschließen ist.

**5.** Elektronische Steuervorrichtung (1) mit einer Eingangsverarbeitungsschaltung (2), die Wählschalter (431, 431, 451, 452) umfasst, die geeignet sind, um zumindest einen aus einer Vielzahl von Pull-up-Widerständen (421, 422) und/oder zumindest einen aus einer Vielzahl von Pull-down-Widerständen (461, 462) mit einem Eingangssignal von außen zu verbinden, wobei die Eingangsverarbeitungsschaltung (2) eine Einheit aufweist, die geeignet ist, um zu diagnostizieren, ob der Widerstandswert des zumindest einen Pull-up-Widerstands (421, 422) und/oder des zumindest einen Pull-down-Widerstands (461, 462) innerhalb eines erwarteten Bereichs liegt,
wobei die Eingangsverarbeitungsschaltung (2) geeignet ist, um den zumindest einen Pull-up-Widerstand (412, 422) oder den zumindest einen Pull-down-Widerstand (461, 462) mit einer extern angeschlossenen Referenzwiderstandgruppe (27,28) zu verbinden, die einen bekannten Widerstandswert aufweist, wobei die extern angeschlossene Referenzwiderstandgruppe (27, 28) weitere Enden aufweist, die mit Leistungsquellenleitung (41) und Masseleitung (47) verbunden sind, und die Einheit, die geeignet ist, um zu diagnostizieren, ob der Widerstandswert des zumindest einen Pull-up-Widerstands (421, 422) und/oder des zumindest einen Pull-down-Widerstands (461, 462) in dem erwarteten Bereich liegt, geeignet ist, um die Diagnose durch Überprüfen, ob die Spannung an einem Punkt (44) zwischen der extern angeschlossenen Referenzwiderstandsgruppe (27, 28), der Vielzahl an Pull-up-Widerständen (421, 422) und der Vielzahl an Pull-down-Widerständen (461, 462) in einem erwarteten Bereich liegt, durchzuführen.

## Revendications

**1.** Dispositif de commande électronique (1) présentant un circuit de traitement d'entrée (2) comprenant des commutateurs de sélection (431, 432, 451, 452) aptes à connecter au moins l'une d'une pluralité de résistances de rappel vers le niveau haut (421, 422) et/ou au moins l'une d'une pluralité de résistances de rappel vers le niveau bas (461, 462), à un signal d'entrée provenant de l'extérieur, le circuit de traitement d'entrée (2) présentant une unité apte à diagnostiquer si la valeur de résistance de ladite au moins une résistance de rappel vers le niveau haut (421, 422) et/ou de ladite au moins une résistance de rappel vers le niveau bas (461, 462) se situe dans une plage attendue ;
dans lequel le circuit de traitement d'entrée (2) est apte à connecter l'une de la pluralité de résistances de rappel vers le niveau bas (461, 462) à ladite au moins une résistance de rappel vers le niveau haut (421, 422), lorsque la valeur de résistance de ladite au moins une résistance de rappel vers le niveau haut (421, 422) doit être diagnostiquée, à connecter l'une de la pluralité des résistances de rappel vers le niveau haut (421, 422) à ladite au moins une résistance de rappel vers le niveau bas (461, 462), lorsque la valeur de résistance de ladite au moins une résistance de rappel vers le niveau bas (461, 462) doit être diagnostiquée, et dans lequel l'unité, apte à diagnostiquer si la valeur de résistance de ladite au moins une résistance de rappel vers le niveau haut (421, 422) et/ou de ladite au moins une résistance de rappel vers le niveau bas (461, 462) se situe dans la plage attendue, est apte à mettre en oeuvre le diagnostic en vérifiant si la tension d'un point intermédiaire (44) entre la pluralité de résistances de rappel vers le niveau haut (421, 422) et la pluralité de résistances de rappel vers le niveau bas (461, 462) se situe dans une plage attendue.

**2.** Dispositif de commande électronique (1) selon la revendication 1, dans lequel :
un rapport des valeurs de résistance de la résistance de rappel vers le niveau haut (421, 422) et de laite au moins une résistance de rappel vers le niveau bas (461, 462) connectées mutuellement dans le cadre du diagnostic de la valeur de résistance, ou le rapport des valeurs de résistance de la résistance de rappel vers le niveau bas (461, 462) et de ladite au moins une résistance de rappel vers le niveau haut (421, 422) connectées mutuellement dans le cadre du diagnostic de la valeur de résistance, est d'environ 1:1.

**3.** Dispositif de commande électronique (1) selon la revendication 1, dans lequel :
l'unité apte à diagnostiquer si la valeur de résistance de ladite au moins une résistance de rappel vers le niveau haut (421, 422) et/ou de ladite au moins une résistance de rappel vers le niveau bas (461, 462) se situe dans la plage attendue, est apte à mettre en oeuvre la vérification visant à déterminer si la tension du point intermédiaire (44) entre la pluralité de résistances de rappel vers le niveau haut (421, 422) et la pluralité de résistances de rappel vers le niveau bas (461, 462) se situe dans la plage attendue, en utilisant un comparateur de fenêtre (51).

**4.** Dispositif de commande électronique (1) selon la revendication 1, comprenant une zone de mémoire de définition (23) qui est indépendante d'autres zones de mémoire, et dans lequel le circuit de traitement d'entrée (2) est configuré de manière à définir la zone de mémoire de définition (23) afin de sélectionner la résistance de rappel vers le niveau haut (421, 422) ou la résistance de rappel vers le niveau bas (461, 462) à connecter pour le diagnostic.

**5.** Dispositif de commande électronique (1) présentant un circuit de traitement d'entrée (2) comprenant des commutateurs de sélection (431, 432, 451, 452) aptes à connecter au moins l'une d'une pluralité de résistances de rappel vers le niveau haut (421, 422) et/ou au moins l'une d'une pluralité de résistances de rappel vers le niveau bas (461, 462), à un signal d'entrée provenant de l'extérieur, le circuit de traitement d'entrée (2) présentant une unité apte à diagnostiquer si la valeur de résistance de ladite au moins une résistance de rappel vers le niveau haut (421, 422) et/ou de ladite au moins une résistance de rappel vers le niveau bas (461, 462) se situe dans une plage attendue ; dans lequel le circuit de traitement d'entrée (2) est apte à connecter ladite au moins une résistance de rappel vers le niveau haut (421, 422), ou ladite au moins une résistance de rappel vers le niveau bas (461, 462), à un groupe de résistances de référence connectées depuis l'extérieur (27, 28) présentant une valeur de résistance connue, dans lequel le groupe de résistances de référence connectées depuis l'extérieur (27, 28) présente d'autres extrémités connectées à un câblage de source d'alimentation (41) et à un câblage de masse, GND, (47), et l'unité apte à diagnostiquer si la valeur de résistance de ladite au moins une résistance de rappel vers le niveau haut (421, 422) et/ou de ladite au moins une résistance de rappel vers le niveau bas (461, 462) se situe dans une plage attendue, est apte à mettre en oeuvre le diagnostic en vérifiant si la tension d'un point intermédiaire (44) entre le groupe de résistances de référence connectées depuis l'extérieur (27, 28), la pluralité de résistances de rappel vers le niveau haut (421, 422) et la pluralité de résistances de rappel vers le niveau bas (461, 462), se situe dans une plage attendue.

FIG. 1

1
2
21
4
5
6
62
41
31
3
32
47
23
24
51
61
421
422
431
44
432
52
53
451
452
25
22
461
462
47

FIG. 2

5
47
41
52
51
511
513
44
512
53
47
41

# FIG. 3

| VOLTAGE RANGE OF V44 | OUTPUT LOGIC | ABNORMALITY PRESENCE/ABSENCE OF PULL-UP RESISTOR OR PULL-DOWN RESISTOR |
|---|---|---|
| V52~V47 | FALSE | ABNORMAL |
| V53~V52 | TRUE | NO ABNORMALITY |
| V47~V53 | FALSE | ABNORMAL |

# FIG. 4

1
2
21
4
6
62
41
31
23
41
24
61
3
421
422
431
44
432
32
451
452
25
22
461
462
47
47

FIG. 5

| VOLTAGE RANGE OF V44 | ABNORMALITY PRESENCE/ABSENCE OF PULL-UP RESISTOR OR PULL-DOWN RESISTOR |
|---|---|
| V52~V47 | ABNORMAL |
| V53~V52 | NO ABNORMALITY |
| V47~V53 | ABNORMAL |

FIG. 6

START JUDGEMENT
V53 < V44 AND
V44 < V52?
Yes
No
JUDGE THAT RESISTOR OF
DIAGNOSIS TARGET IS NORMAL
JUDGE THAT RESISTOR OF
DIAGNOSIS TARGET IS MALFUNCTIONING
FINISH JUDGEMENT

*FIG. 7*

1
2
21
4
6
62
26
41
31
27
23
41
61
421
422
3
431
44
432
32
451
452
22
461
462
47
28
47

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP H321004 B
- JP 2001244813 A